# EUROPEAN PATENT SPECIFICATION

(11) **EP 1 464 209 B1**
(45) Date of publication and mention of the grant of the patent: **12.12.2007**
(21) Application number: 02805869.1
(22) Date of filing: 18.12.2002
(51) Int. Cl.: H05B 41/288

(54) **ELECTRONIC CIRCUIT, AND METHOD OF OPERATING A HIGH-PRESSURE LAMP**
ELEKTRONISCHE SCHALTUNG UND VERFAHREN ZUM BETRIEB EINER HOCHDRUCKLAMPE
CIRCUIT ELECTRONIQUE ET PROCEDE D'EXPLOITATION D'UNE LAMPE HAUTE PRESSION

(30) Priority: 02.01.2002 DE 10200004
(43) Date of publication of application: 06.10.2004
(73) Proprietor: Philips Intellectual Property & Standards GmbH, 20099 Hamburg (DE); Koninklijke Philips Electronics N.V., 5621 BA Eindhoven (NL)
(72) Inventor: LÜRKENS, Peter, Philips I.P. & Standards GmbH, 52066 Aachen (DE)
(74) Representative: Volmer, Georg
(86) International application number: PCT/IB2002/005746
(87) International publication number: WO 2003/056886

(56) References cited:
- WO-A-02/104083
- GB-A- 2 319 677
- US-A- 5 932 976
- US-A- 6 020 691
- US-A1- 2001 020 830
- US-B1- 6 380 694

## Description

The invention relates to an electronic circuit and to a method of operating a high-pressure lamp in an ignition mode and in a normal operational mode.

Such circuits are known from the prior art, for example from US 4,734,624. The circuit known from the cited US document is shown in Fig. 7 and will be explained in detail below. It comprises a DC-AC converter which comprises the four transistors I1, I2, I3, and I4, such that the transistors I2 and I3, as well as I1 and I4 are connected in series, respectively, thus forming a half bridge each time. The two half bridges are connected in parallel between an operating potential (+) and a reference potential (-). A freewheel diode 21 to 24 is connected in parallel to each of the individual transistors I1 to I4. The half bridges act as a DC-AC converter and provide a suitable AC current for the operation of the high-pressure lamp in the ignition mode or in the normal operational mode. The high-pressure lamp itself forms part of a series circuit comprising a first coil 1, followed by the high-pressure lamp L, and followed again by a second coil 3. This series circuit is connected between the outputs S and T of the two half bridges. The series circuit is completed with a capacitor 2 which is connected in parallel to the high-pressure lamp L and the second coil 3.

As long as the high-pressure lamp has not been ignited, it represents an interruption of said series circuit. This interruption, however, is bridged by the capacitor 2, so that the two half bridges are interconnected by the capacitor 2. An independent operation of the two half bridges is accordingly not possible, also in the non-ignited state of the high-pressure lamp L.

The first coil 1 and the capacitor 2 are to be dimensioned for the normal operational mode such that they act as a filter for filtering out the AC component from the lamp current. They are definitely not operated in a resonant mode during this, i.e. the switching frequencies of the two transistors I2 and I3 are substantially higher than the resonance frequency of a resonant circuit formed by the first coil 1 and the capacitor 2.

The first coil 1 and the capacitor 2 are to be operated at their resonance frequency in the ignition mode by contrast, so as to generate a high voltage required for igniting the high-pressure lamp L. It is necessary for this that the capacitor 2 is constructed so as to be resistant to high voltages, i.e. for a few kV. In addition, the first coil 1 should be dimensioned such that it does not enter the saturated state even when loaded by an ignition current, which is approximately ten times stronger than the current during normal operation,

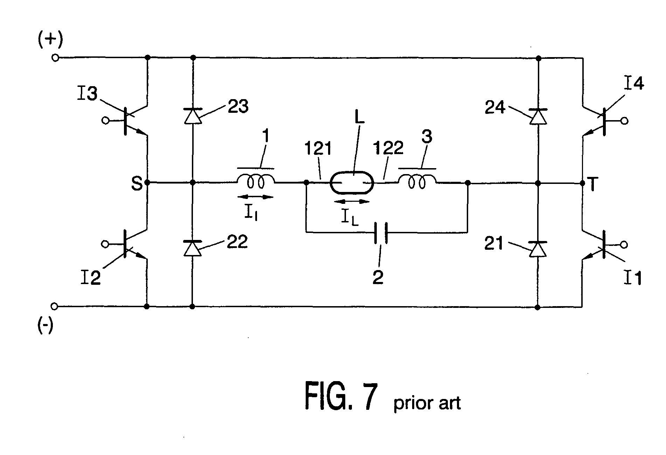

The prior art embodiments show that a completely different dimensioning of the components, in particular of the first coil 1 and the capacitor 2, is necessary for the ignition mode as compared with the normal operational mode. The circuit known from the prior art and shown in Fig. 7, therefore, can be usefully employed basically either for an ignition mode or for a normal operational mode. It is indeed possible to use the circuit of Fig. 7 for a combination of ignition mode and normal operational mode, but in that case the first coil 1 and the capacitor 2 will be strongly overdimensioned for the normal operational mode if it is to be capable of realizing the ignition mode as well.

A further disadvantage of the circuit of Fig. 7 is that strong high-frequency synchronous interference voltages, which arise during switching of the switching elements I1 ... I4, can be transmitted unchecked to the connection lines 121, 122 of the high-pressure lamp L because the two half bridges are not decoupled, but are coupled via the capacitor 2. Losses will eventually occur during switching of the transistors I1 ... 14 which are higher in proportion as the switching frequencies are higher. No measures are taken in the circuit of Fig. 7 for reducing these losses.

From US 2001/0020830A1 a resonant circuit for igniting a lamp in ignition mode is provided by a series of inductors and capacitor. The capacitor may act as tapping point of the inductor. A filter circuit is further provided with a second inductor and a further capacitor.

Starting from the cited US 4,734,624., it is accordingly an object of the invention to develop the circuit for supplying high-pressure lamps disclosed therein further such that it renders possible both an ignition mode and a normal operational mode, i.e. a stable continuous operation, of a high-pressure lamp without the components of the circuit having to be overdimensioned.

This object is achieved by the characterizing features of claim 1. More accurately, the object of the invention is achieved in that the capacitor 2 known from Fig. 7, denoted first capacitor hereinafter, is switched from the junction point between the first coil and the high-pressure lamp either to the reference potential or to the operating potential, and in that a second capacitor is provided, which is switched from the junction point between the high-pressure lamp and the second coil either to the reference potential or to the operating potential.

The arrangement of the capacitors in accordance with the invention achieves that the two half bridges are operated in a decoupled manner in principle, i.e. at least as long as the high-pressure lamp is not ignited. This is also true for the case in which the second capacitor is connected in parallel to the high-pressure lamp, because according to the invention at least the high-frequency components can be drained off via the common junction point - i.e. between the first coil and the high-pressure lamp - and the first capacitor also in this case.

The decoupling of the two half bridges described above renders possible an independent construction and dimensioning of both a first resonant circuit, also denoted filter circuit, comprising the first coil and the first capacitor for filtering out high-frequency components from the lamp current, in particular in the operational mode, and of a second resonant circuit comprising the second coil and the second capacitor for igniting the high-pressure lamp in the ignition mode. The second coil fulfills an additional filtering function in the operational mode in that it filters out high-frequency components from the lamp current.

The circuit according to the invention thus renders it possible to realize a filtering function in the normal operational mode as well as an ignition function in an ignition mode by means of independent circuit elements, i.e. the filter circuit and the second resonant circuit. The two resonant circuits are dimensioned and operated independently of one another. An overdimensioning of in particular the first coil and the first capacitor in the filter circuit is not necessary, according to the invention, because the filter circuit does not have to realize also the ignition function.

Furthermore, the two terminals of the high-pressure lamp according to the invention are connected either to the operating potential or to the reference potential via the first and the second capacitor - at least for high-frequency components. The high-frequency interference peaks arising in the half bridges, for example owing to switching of the switching elements, are automatically and advantageously drained off through the capacitors before reaching the high-pressure lamp in this manner. The actual current through the high-pressure lamp itself is accordingly advantageously at least substantially free from HF interference peaks. The supply leads to the high-pressure lamp are also free from DC interference voltages then.

To reduce the switching losses in the transistors of the half bridges, various embodiments for capacitor arrangements connected in parallel to the transistors are proposed in the dependent claims.

Advantageously, the circuit according to the invention comprises a current control for adjusting the amplitude of the current through the high-pressure lamp.

The object of the invention mentioned above is furthermore achieved by a method of operating a high-pressure lamp as claimed in claim 8. The advantages of this method correspond substantially to the advantages mentioned above for the circuit. In addition to these advantages, the claimed method offers the possibility of operating the second resonant circuit L2, C2 not only at its natural resonant frequency, but alternatively also at an odd fraction of its resonant frequency, which has the advantage that the losses in the ignition mode are clearly reduced, in particular in the switching elements of the second half bridge.

Further advantageous embodiments of the circuit according to the invention and of the method according to the invention for the operation thereof are the subject of the dependent claims.

The invention is illustrated in seven Figures, in which:
Fig. 1 shows a first embodiment of the circuit according to the invention;
Fig. 2 shows the lamp voltage during resonant excitation in the ignition mode;
Fig. 3 shows the lamp current in a run-up phase of the high-pressure lamp;
Fig. 4 shows the lamp current in a positive half wave in the normal operational mode;
Fig. 5 shows a circuit not being part the invention;
Fig. 6 shows a further embodiment of the claimed electronic circuit; and
Fig. 7 shows a circuit known from the prior art for operating a high-pressure lamp.

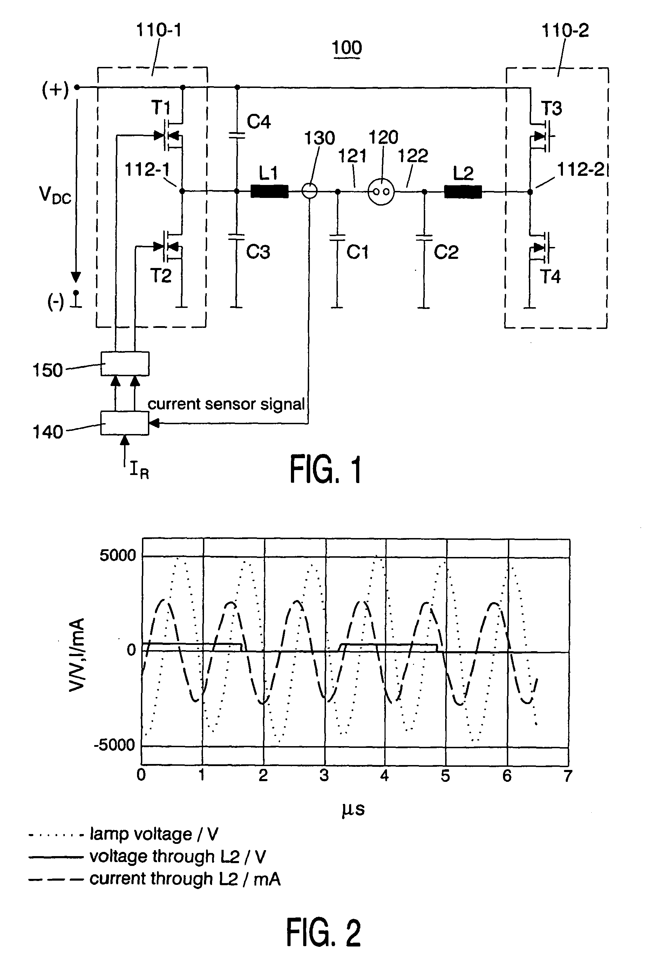

The hardware construction of a preferred embodiment of the claimed circuit will be explained in detail below with reference to Fig. 1, followed by an explanation of its operation in various operational modes with reference to Figs. 2 to 4.

Fig. 1 shows a preferred embodiment of the electronic circuit 100 according to the invention for operating a high-pressure lamp 120 in various operational modes, in particular in an ignition mode, a run-up mode, and a normal operational mode.

The circuit 100 comprises a DC-AC converter consisting of a first half bridge 110-1 and a second half bridge 110-2 for providing a suitable alternating current for the high-pressure lamp 120 in said operational modes. The first half bridge 110-1 consists of two switching elements connected in series, preferably power transistors T1, T2, a DC voltage V_{DC} being applied to this series arrangement. The DC voltage is given by a potential difference between an operating potential (+) and a reference potential (-). The second half bridge 110-2 is constructed so as to be symmetrical to the first half bridge 110-1. The second half-bridge 110-2 comprises two switching elements connected in series, preferably power transistors T3 and T4, which second half bridge 110-2 is connected to said DC voltage V_{DC} in parallel to the first half bridge 110-1.

In addition to the two half bridges 110-1, 110-2, the circuit 100 according to the invention comprises a series arrangement which connects the output 112-1 of the first half bridge 110-1 to the output 112-2 of the second half bridge 110-2. The series arrangement comprises a first coil L1, followed by the high-pressure lamp 120 connected via a first supply line 121, followed again by a second supply line 122 and a second coil L2. The connection terminal of the first coil L1 not connected to the high-pressure lamp 120 is connected to the output 112-1 of the first half bridge 110-1, and the connection terminal of the second coil L2 not connected to the high-pressure lamp 120 is connected to the output 112-2 of the second half bridge 110-2.

A first capacitor C1 is connected in the path from the junction point of the first coil L1 and the high-pressure lamp 120 either to the operating potential (+) (not shown in Fig. 1) or to the reference potential (-). In addition, a second capacitor C2 is connected in the path from the junction point of the high-pressure lamp 120 and the second coil L2 either to the operating potential (+) (not shown in Fig. 1) or to the reference potential (-).

The embodiment of the electronic circuit according to the invention shown in Fig. 1 further comprises several components for achieving a control of the lamp current level. For this purpose, a sensor device 130 is provided between the first coil L1 and the connection terminal of the first capacitor C1 for generating a current sensor signal which represents the level of the current through the first coil L1. This current sensor signal is supplied to a comparator device 140 which compares the level of the current through the first coil L1 represented by the current sensor signal with a given reference current value I_{R}, generating control signals for achieving a suitable control of the switching elements T1, T2 of the first half bridge 110-1 in dependence on the result of this comparison. More in detail, said control signals are arranged such that they vary the duty cycles of the individual switching elements T1 and/or T2 of the first half bridge 110-1 such that the average value of the current through the first coil L1 is adjusted to the desired value of the lamp current. The duty cycle defines the ratio of the switch-on time of a switching element to the cycle duration, for example of the current. The control of the current through the first coil L1 at the same time controls the instantaneous value of the lamp current through the high-pressure lamp 120 because of the arrangement of the circuit according to the invention.

In addition to the comparator device 140 described above, a delay device 150 may be provided for delaying the control signals by a given delay time with respect to the moment when it is detected that the level becomes too high or too low in comparison with the reference current value I_{R}. This delay time has a damping influence of the control. The delay time is preferably chosen such that at least a desired critical damping adjusts itself in the filter circuit comprising the second coil L2 and the first capacitor C1, so that any control deviation detected is compensated without overshoot. At the same time, the delay time is adjusted such that the current through the first coil L1 changes its sign at least twice during one switching cycle.

The operation of the circuit described above and shown in Fig. 1 will be explained below for various operational modes.

### 1. Ignition Mode

In the non-ignited state, the high-pressure lamp 120 is to be regarded as an interruption, i.e. it disconnects the first half bridge 110-1 with the filter circuit connected thereto, comprising the first coil 1 and the first capacitor C1, from the second half bridge 110-2 with the second resonant circuit connected thereto, comprising the second coil L2 and the second capacitor C2. This decoupling renders it possible to excite the second resonant circuit at its natural resonance frequency f_{R2} so as to make available a sufficiently high ignition voltage for the high-pressure lamp 120. The excitation of the resonance necessary for this in the second resonant circuit takes place such that the switching elements T3 and T4 of the second half bridge 110-2 are switched on and off in alternation either at said resonance frequency f_{R2} or an odd fraction thereof. The resonant resistance of the second resonant circuit is suitably chosen such that, at the ignition voltage of, for example, 5 kV necessary for the high-pressure lamp 120, the current in the second coil L2 is not higher than the maximum lamp current during a normal operational mode yet to be described below. Such a construction will lead to the high resonance frequency mentioned above.

If the desired ignition voltage is to be generated only through excitation of the second resonant circuit with an odd fraction, for example 1/5 or 1/3, of the resonance frequency f_{R2}, then the minimum quality of the second resonant circuit must be made correspondingly higher. Fig. 2 shows the current and voltage gradients in the second coil L2 and the resulting ignition voltage for the high-pressure lamp 120 in the case of resonant excitation of the ignition voltage by means of the third harmonic.

Typically, the first capacitor C1 is constructed so as to be considerably larger than the second capacitor C2; for example, C1 = 150 nF and C2 = 82 pF. In this construction, for example, the second coil L2 is so constructed that a resonance frequency overall of, for example, 1 MHz is obtained for the second resonant circuit.

According to the invention, the second resonant circuit is constructed such that it must be operated at its natural resonance frequency f_{R2} in the ignition mode during a comparatively short resonance period or ignition period of no more than a few seconds, for example 1 or 2 seconds, so as to achieve the ignition of the high-pressure lamp 120. This comparatively short ignition time according to the invention has the advantage that the switching elements T3 and T4 in the second half bridge 110-2 are also switched over at said resonance frequency or an odd fraction thereof during this short period only. The high-frequency switching operation of the switching elements T3 and T4 give rise to high losses therein, but these are acceptable because of the short duration of the ignition operation.

During ignition, the switching element T1 of the first switching bridge 110-1 is preferably fully switched on, whereas the second switching element T2 is switched off, so that the junction point between the first capacitor C1 and the high-pressure lamp 120 is permanently connected to a high potential. As long as the high-pressure lamp 120 has not yet ignited, i.e. no lamp current can flow, this lamp is not controlled by the first half bridge 110-1 either.

When the high-pressure lamp finally ignites, it will first be in a so-called glow discharge state. In the glow discharge state, the high-pressure lamp requires an operating voltage of approximately 300 V, which is substantially lower than the ignition voltage but still comparatively high in comparison with an operating voltage of 75 V necessary for normal operation, as will be described further below. In the glow discharge state, the voltage drop across the high-pressure lamp 120 serves as a countervoltage, and it is necessary to drive a sufficiently strong current through the high-pressure lamp 120 against this countervoltage for achieving that its electrodes heat up sufficiently, so that the high-pressure lamp 120 will enter a subsequent luminous arcing mode. The glow discharge operation damps the second resonant circuit C2, L2 to the extent that a voltage adjusts itself across the second coil L2 which is just sufficient for driving the required current through the high-pressure lamp 120. The drop in voltage across the second coil L2 also causes its current to drop to the same relative degree. If this current through the second coil L2 becomes too weak for providing a sufficiently strong current to the high-pressure lamp 120, this drop may be counteracted by a decrease in the operating frequency of the second resonant circuit. Alternatively to a drop in the operating frequency of the second resonant circuit, a switch may be made to normal operation as described further below, because here it is possible to generate at most the operational DC voltage V_{DC}, approximately 400 V, for the high-pressure lamp 120. It should be noted, however, that the operating voltage V_{DC} of the circuit is not identical to the average operating voltage of the high-pressure lamp 120 in normal operation, which lies at approximately 75 V, as was noted above.

If the ignition voltage for the high-pressure lamp 120 is not generated by the second resonant circuit C2, L2 being operated at its natural resonance frequency f_{R2}, but instead at an odd fraction thereof, the advantage will arise that the lower switching frequency reduces the switching losses in the switching elements T3 and T4 in the second half bridge 110-2 as compared with the pure resonant operation at f_{R2}, while at the same time the glow discharge current through the high-pressure lamp 120 is increased in comparison with the resonant operation by the factor of the fraction; i.e. in comparison with an operation at the actual resonance frequency, the glow discharge current is greater by a factor 3 in the case of excitation by merely 1/3 of the resonance frequency.

### 2. Run-Up Mode

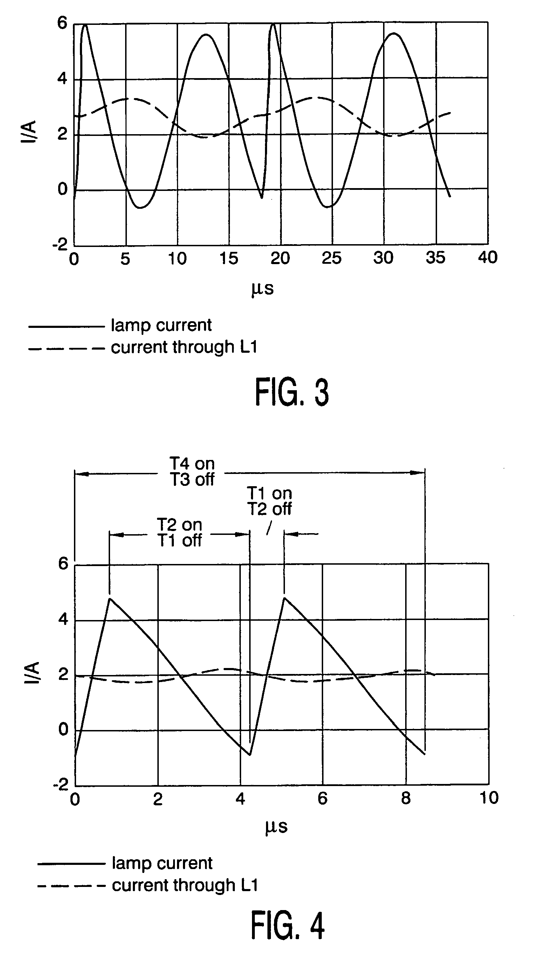

After the glow discharge, the high-pressure lamp 120 enters a luminous arcing mode in which it initially has a very low burning voltage of approximately 15 V. A current flows already through the high-pressure lamp 120 both in the glow discharge and in the luminous arcing mode, so that the current control described above with reference to Fig. 1 is operational already in principle. The very low operating voltage which establishes itself in the luminous arcing mode, however, leads to a drop in the switching frequencies of the switching elements T1 and T2 in the first half bridge 110-1. This may proceed to the point that at the start of lamp operation, i.e. in the luminous arcing mode, the switching frequency may drop to below the resonance frequency of the first resonant circuit comprising the first coil L1 and the first capacitor C1. This will then have the result that a stable current control is no longer possible. It was found, however, that a useful operation of the current control is nevertheless made possible if the minimum switch-on duration of the switching elements T1, T2 is limited in downward direction. This does give rise to an irregular switching pattern for the switching elements T1 and T2, as is shown in Fig. 3, with strong noise components in the lamp current, but the average lamp current remains continuously controllable. The irregular switching pattern manifests itself in the irregular time durations of the rising and falling edges in the current through the first coil L1, because the first switching element T1 is switched on and the second switching element T2 is switched off during each rising edge, whereas in the opposite case, i.e. during the falling edges, the first switching element T1 is switched off and the second switching element T2 is switched on.

### 3. Normal Operational Mode

After the run-up phase, the high-pressure lamp 120 enters the normal operational mode. In this normal operational mode, the high-pressure lamp is supplied with a low-frequency alternating current whose basic frequency is given by the switching frequency of the switching elements T3 and T4 of the second half bridge 110-2.

Fig. 4 shows an example of a positive half wave of the pulsatory alternating current through the high-pressure lamp 120. The switching element T4 is switched on and the switching element T3 is switched off during the positive half wave. While the switching elements T3 and T4 of the second half bridge 110-2 are switched on and off alternately in accordance with the desired basic frequency of the lamp current, the duty cycles of the switching elements T1 and T2 of the first half bridge 110-1 are controlled by the current control described above with reference to Fig. 1 such that an average DC current level adjusts itself in the first coil L1, which level corresponds to the desired current through the high-pressure lamp 120.

It is apparent from Fig. 4 that the switching frequencies of the switching elements T1 and T2 are substantially higher than the switching frequencies of the switching elements T3 and T4. More precisely, the switching element T4 remains switched on throughout the time period covered by Fig. 4, and the switching element T3 remains switched off throughout this entire period, whereas the switching element T1 is switched on during each rising edge of the current through the first coil L1 and is switched off for the duration of the falling edges. By contrast, the switching element T2 is switched off during the rising edges of the current through the first coil L1 and switched on for the duration of the falling edges.

The high switching frequencies, in particular of the switching elements in the first half bridge 110-1, may give rise to high losses therein. These losses may be substantially reduced by a so-termed voltageless switching of the switching elements T1, T2. This voltageless switching may be achieved in that each switching element T1 and T2 is given a respective parallel capacitor C4 and C3, and in that the high-frequency alternating current through the first coil L1 passes the zero line both in downward and in upward direction in each switching cycle. To realize the latter, the first switching element T1 is first switched on and the second switching element T2 of the first half bridge 110-1 is switched off. This switching configuration achieves that the current through the first coil L1 rises to a high positive value. Once this current has reached a desired threshold value, the switching states of the switching elements T1 and T2 are changed over after a given delay time realized by the delay circuit 150, so that then the switching element T1 is switched off. The current, which first further flows from the half bridge 110-1 as in the first switching configuration, then starts to re-charge the capacitors C3 and C4. More accurately, the re-charging takes place such that the voltage across the capacitor C3, and thus at the output 112-1 of the first half bridge 110-1, drops, whereas the voltage across the capacitor C4 rises. When the voltage at the output 112-1 has reached the value "0", a diode present in the switching element T2, if the latter is constructed as a MOSFET transistor, becomes conductive, and the current in the first coil L 1 starts to decrease. Now the second switching element T2 can be switched on without losses.

The typical operating voltage of the high-pressure lamp 120 in the normal operational mode, i.e. of approximately 75 V, is now present across the capacitor C1. This voltage causes the current in the first coil L1 to decrease further until it finally drops below the zero line, as is shown in Fig. 4. Now the second switching element T2 of the first half bridge 110-1 can be switched off without losses. The current through the high-pressure lamp 120 and through the first coil L1 flows into the first half bridge 110-1 again starting from this moment and again starts to charge the capacitors C3 and C4, so that the voltage at the output 112-1 of the first half bridge rises again. When it finally reaches the level of the supply voltage again, a diode in the first switching element T1, if this is constructed as a MOSFET transistor, becomes conductive. The cycle described above with the current rise through the first coil L1 then starts from scratch again. A loss-free switching on and off of the switching elements T1 and T2 can be continually maintained in this manner.

After the current direction has been reversed, i.e. in the negative half wave, the switching element T4 is switched off and the switching element T3 of the second half bridge 110-2 is switched on. The first half bridge 110-1 is now controlled by the current control such that the average current flows into the first half bridge.

The capacitor C1 drains off the high-frequency component of the current through the first coil L1 to the reference potential (-). At the same time, the second coil L2 represents a barrier for any remaining portions of high-frequency components in the lamp current.

As was noted above, the second capacitor C2 with the second coil L2 forms a second resonant circuit whose resonance frequency typically is a multiple of the switching frequency of the first half bridge. In the normal operational mode, accordingly, the second resonant circuit is normally operated at a frequency far below its resonance frequency, which is why any remaining high-frequency current in the capacitor C2 is only very small. If, for example, the first capacitor C1 is chosen to be 150 nF and the second capacitor 82 pF, the remaining alternating current in the second capacitor C2 amounts to no more than approximately 0.1 % of the alternating current through the first capacitor C1.

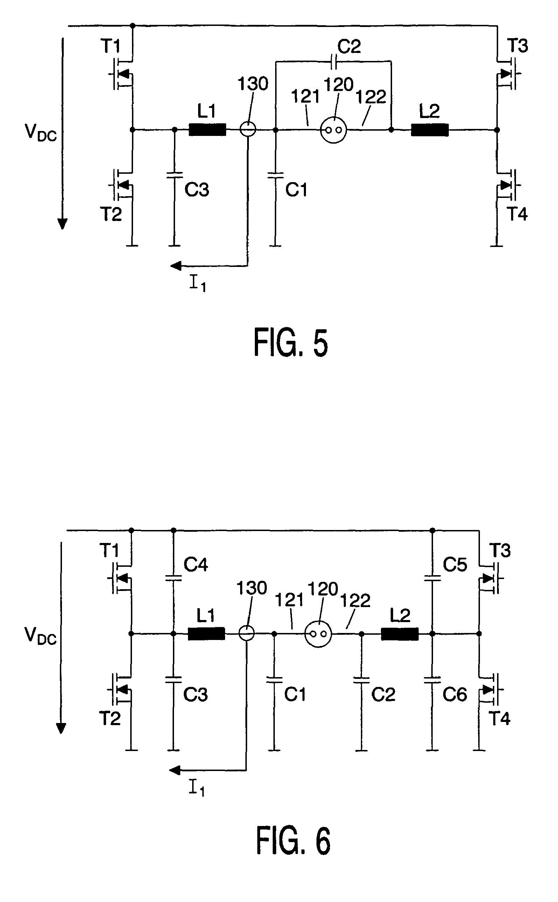

Fig. 5 shows a further circuit not being part of the invention. Its operation is the same as that of the embodiment shown in Fig. 1. The essential difference with the embodiment shown in Fig. 1 is that the second capacitor C2 is not connected to the reference potential (-) but lies in parallel to the high-pressure lamp 120. This circuit arrangement has the same effect as the circuit configuration shown in Fig. 1 at least in the ignition mode or generally in the case in which a high-frequency current flows through the capacitor C2, because the first capacitor C1 represents a short-circuit to the reference potential (-) for high-frequency currents. The second capacitor C2 would then also be connected - as in Fig. 1 - between the junction point of the high-pressure lamp 120 and the second coil L2 on the one hand and the reference potential (-) on the other hand.

It was furthermore found that a loss-free switching of the switching elements T1 and T2 can also be realized with only one capacitor, in particular the third capacitor C3, in particular at high-frequency currents. The fourth capacitor C4 would then be unnecessary.

Fig. 6 shows a further embodiment of the circuit according to the invention. It differs from the first embodiment shown in Fig. 1 exclusively in that capacitors are also provided parallel to the switching elements of the second half bridge 110-2. In particular, a fifth capacitor C5 is connected in parallel to the third switching element T3, and a sixth capacitor C6 in parallel to the fourth switching element T4. These capacitors render possible a reduction in the switching losses of the switching elements T3 and T4, similar to the action of the capacitors C3 and C4. They are particularly advantageous in the ignition mode, because the losses in the switching elements are particularly high then because of the particularly high switching frequencies. The capacitors C5 and C6 in addition provide an advantageous reduction in the edge steepness of the voltage at the output of the half bridge 110-2. This again is advantageous for the suppression of HF interference.

The current control in the embodiment of Fig. 6 operates in the same manner as the one described with reference to Fig. 1 above.

## Claims

1. An electronic circuit (100) for operating a high-pressure lamp (120) in an ignition mode and a normal operational mode, comprising
- a DC-AC converter comprising a first and a second half bridge (110-1, 110-2) which are connected in parallel between an operating potential (+) and a reference potential (-) for providing a suitable alternating current to the high-pressure lamp (120) in the two said operating modes; and
- a series arrangement comprising a first coil (L1), followed by the high-pressure lamp (120), again followed by a second coil (L2), while the connection terminal of the first coil (L1) not connected to the high-pressure lamp (120) is connected to the output (112-1) of the first half-bridge (110-1), and the connection terminal of the second coil (L2) not connected to the high-pressure lamp (120) is connected to the output (112-2) of the second half-bridge (110-2), said outputs being each formed by a central tap of a half bridge; **characterized by**,
- a first capacitor (C1) which is connected in the path from the junction point of the first coil (L1) and the high-pressure lamp (120) either to the reference potential (-) or to the operating potential (+) such that
- the first coil (L1) and the first capacitor (C1) together form a filter which at least in operational mode filters out at least high frequency components from the current flowing through the high-pressure lamp (120), and
- a second capacitor (C2) which is connected in the path from the junction point of the high-pressure lamp (120) and the second coil (L2) either to the reference potential (-) or to the operating potential (+) such that,
- the second coil (L2) and the second capacitor (C2) together form a resonant circuit which in the ignition mode is supplied with a voltage provided by the second half bridge (110-2), so as to generate an ignition voltage necessary for igniting the high- pressure lamp (120),
- wherein the arrangement of the capacitors (C1, C2) is in such a way, that in the non-ignited mode, the high pressure lamp (120) disconnects the first half bridge (110-1) with the filter circuit connected thereto, comprising the first coil 1 and the first capacitor (C1), from the second half bridge (110-2) with the second resonant circuit connected thereto, comprising the second coil (L2) and the second capacitor (C2), in order to excite the second resonant circuit at its natural resonance frequency f_{R2} so as to make available a sufficiently high ignition voltage for the high-pressure lamp (120).

2. A circuit as claimed in claim 1, **characterized in that** a third capacitor (C3) is connected between the output (112-1) of the first half bridge (110-1) and either the operating potential (+) or the reference potential (-).

3. A circuit as claimed in claim 1, **characterized in that** a third capacitor (C3) is connected between the output (112-1) of the first half bridge (110-1) and the reference potential (-), and **in that** a fourth capacitor (C4) is connected between the operating potential (+) and the output (112-1) of the first half bridge (110-1).

4. A circuit as claimed in claim 1, **characterized in that** a fifth capacitor (C5) is connected between the output of the second half bridge (112-2) and the operating potential (+), and/or **in that** a sixth capacitor (C6) is connected between the reference potential (-) and the output (112-2) of the second half bridge (110-2).

5. A circuit as claimed in claim 1, **characterized by**
- a sensor device (130) for generating a current-sensor signal which represents the value of the current through the first coil (L1); and by
- a comparator device (140) for comparing the value represented by the current-sensor signal with a given reference current value I_{R} and for generating at least one control signal for controlling the level of the current through the first coil (L1) and through the high-pressure lamp (120) to the given reference current value I_{R} through a suitable variation of the duty cycles of the switching elements (T1, T2) of the first half bridge (110-1).

6. A circuit as claimed in claim 5, **characterized in that** the sensor device (130) is constructed as a magnetoresistive sensor.

7. A circuit as claimed in claim 5, **characterized by** a delay device (150) for delaying the control signal for controlling the switching elements (T1, T2) of the first half bridge (110-1) by a given delay time with respect to the moment when it is detected that the level exceeds the reference value I_{R} in upward or downward direction, which delay time is defined such that at least a desired critical damping establishes itself in a filter comprising the second coil (L2) and the first capacitor (C1), and that the current through the first coil (L1) changes its sign at least twice during a switching cycle of the switching elements (T1, T2) of the first half bridge.

8. A method of operating a high-pressure lamp (120) with a circuit as claimed in claim 1, wherein
- in an ignition mode
- supplying the high-pressure lamp (120) with a voltage from the second half bridge (110-2) with an alternating current, whose frequency corresponds to a resonance frequency of the resonant circuit composed of the second coil (L2) and the second capacitor (C2) or to an odd fraction thereof, and generating an ignition voltage necessary for igniting the high-pressure lamp (120),
- decoupling the first coil (L1) and the first capacitor (C1) from the second coil (L2) and the second capacitor (C2) by the high-pressure lamp (120),
- exciting the resonant circuit at its natural resonance frequency due to the decoupling so as to make available sufficiently high ignition voltage for the high pressure lamp (120),
at least in an operational mode
- the current through the high-pressure lamp has on the one hand a low-frequency component generated by a low-frequency switching of the second half-bridge (T3, T4) and on the other hand a high-frequency component generated by a high-frequency switching of the first half-bridge (T1, T2),
- filtering out at least substantially high frequency components from a current flowing through the high-pressure lamp (120) by the filter composed of the first coil (L1) and the first capacitor (C1), and
- draining off high frequency components of the current through the first capacitor (C1), wherein the arrangement of the capacitors (C1, C2) decouples the first half bridge (110-1) from the second half bridge (110-2) at least in the ignition mode.

9. A method as claimed in claim 8, **characterized in that** the ignition mode is maintained for at least one second, and **in that** immediately after that a switch is made to the normal operational mode.

10. A method as claimed in claim 9, **characterized in that** after ignition of the high-pressure lamp (120) the switching Frequency of the second half bridge (110-2), and thus the frequency of the current through the high-pressure lamp (120), is reduced.

11. A method as claimed in claim 8, **characterized in that** the switching elements (T1, T2, T3, T4) of the first half bridge (110-1) and/or the second half bridge (110-2) are operated by the principle of voltageless switching.

## Patentansprüche

1. Elektronische Schaltung (100) zum Betreiben einer Hochdrucklampe (120) in einem Zündmodus und einem normalen Betriebsmodus, mit
- einem Wechselrichter, der eine erste und eine zweite Halbbrücke (110-1, 110-2) umfasst, welche parallel zwischen ein Betriebspotential (+) und ein Bezugspotential (-) geschaltet sind, um einen geeigneten Wechselstrom für die Hochdrucklampe (120) während der beiden genannten Betriebsmodi bereitzustellen; und
- einer Reihenschaltung, umfassend eine erste Spule (L1), dieser nachgeschaltet die Hochdrucklampe (120) und dieser nachgeschaltet eine zweite Spule (L2), wobei der Anschluss der ersten Spule (L1), welcher nicht mit der Hochdrucklampe (120) verbunden ist, mit dem Ausgang (112-1) der ersten Halbbrücke (110-1) verbunden ist und der Anschluss der zweiten Spule (L2), welcher nicht mit der Hochdrucklampe (120) verbunden ist, mit dem Ausgang (112-2) der zweiten Halbbrücke (110-2) verbunden ist, wobei die Ausgänge jeweils durch eine Mittelanzapfung einer Halbbrücke gebildet sind; **gekennzeichnet durch**
- einen ersten Kondensator (C1), welcher in den von dem Verbindungspunkt zwischen der ersten Spule (L1) und der Hochdrucklampe (120) entweder zum Bezugspotential (-) oder zum Betriebspotential (+) verlaufenden Pfad geschaltet ist; so dass
- die erste Spule und der erste Kondensator (C1) zusammen ein Filter bilden, das mindestens im Betriebsmodus mindestens Hochfrequenzanteile aus dem durch die Hochdrucklampe (120) fließenden Strom ausfiltert, und
- einen zweiten Kondensator (C2), welcher in den von dem Verbindungspunkt zwischen der Hochdrucklampe (120) und der zweiten Spule (L2) entweder zum Bezugspotential (-) oder zum Betriebspotential (+) verlaufenden Pfad geschaltet ist, so dass
- die zweite Spule (L2) und der zweite Kondensator (C2) zusammen einen Resonanzkreis bilden, der im Zündmodus mit einer von der zweiten Halbbrücke (110-2) bereitgestellten Spannung gespeist wird, um eine zum Zünden der Hochdrucklampe (120) erforderliche Zündspannung zu erzeugen,
- wobei die Anordnung der Kondensatoren (C1, C2) derart ist, dass im nicht gezündeten Modus die Hochdrucklampe (120) die erste Halbbrücke mit der damit verbundenen Filterschaltung, die die erste Spule 1 und den ersten Kondensator (C1) umfasst, von der zweiten Halbbrücke (110-2) mit dem damit verbundenen zweiten Resonanzkreis, der die zweite Spule (L2) und den zweiten Kondensator (C2) umfasst, trennt, um den zweiten Resonanzkreis bei seiner Eigenresonanzfrequenz f_{R2} anzuregen, um eine genügend hohe Zündspannung für die Hochdrucklampe (120) zur Verfügung zu stellen.

2. Schaltung nach Anspruch 1, **dadurch gekennzeichnet, dass** ein dritter Kondensator (C3) zwischen den Ausgang (112-1) der ersten Halbbrücke (110-1) und entweder das Betriebspotential (+) oder das Bezugspotential (-) geschaltet ist.

3. Schaltung nach Anspruch 1, **dadurch gekennzeichnet, dass** ein dritter Kondensator (C3) zwischen den Ausgang (112-1) der ersten Halbbrücke (110-1) und das Bezugspotential (-) geschaltet ist und dass ein vierter Kondensator (C4) zwischen das Betriebspotential (+) und den Ausgang (112-1) der ersten Halbbrücke (110-1) geschaltet ist.

4. Schaltung nach Anspruch 1, **dadurch gekennzeichnet, dass** ein fünfter Kondensator (C5) zwischen den Ausgang der zweiten Halbbrücke (112-2) und das Betriebspotential (+) geschaltet ist und/oder dass ein sechster Kondensator (C6) zwischen das Bezugspotential (-) und den Ausgang (112-2) der zweiten Halbbrücke (110-2) geschaltet ist.

5. Schaltung nach Anspruch 1, **gekennzeichnet durch**
- eine Sensoreinrichtung (130) zum Erzeugen eines Stromsensorsignals, welches den Wert des Stroms **durch** die erste Spule (L1) repräsentiert; und
- eine Komparatoreinrichtung (140) zum Vergleichen des **durch** das Stromsensorsignal repräsentierten Wertes mit einem vorgegebenen Referenzstromwert I_{R} und zum Erzeugen mindestens eines Regelsignals zum Regeln des Pegels des Stroms **durch** die erste Spule (L1) und **durch** die Hochdrucklampe (120) auf den vorgegebenen Referenzstromwert I_{R} **durch** geeignetes Variieren der Tastgrade der Schaltelemente (T1, T2) der ersten Halbbrücke (110-1).

6. Schaltung nach Anspruch 5, **dadurch gekennzeichnet, dass** die Sensoreinrichtung (130) als magnetoresistiver Sensor ausgebildet ist.

7. Schaltung nach Anspruch 5, **gekennzeichnet durch** eine Verzögerungseinrichtung (150) zum Verzögern des Regelsignals zum Ansteuern der Schaltelemente (T1, T2) der ersten Halbbrücke (110-1) um eine vorbestimmte Verzögerungszeit in Bezug auf den Zeitpunkt, zu dem festgestellt wird, dass der Pegel den Referenzwert IR über- oder unterschreitet, wobei die Verzögerungszeit so definiert ist, dass sich bei einem Filter, das die zweite Spule (L2) und den ersten Kondensator (C1) umfasst, mindestens eine gewünschte kritische Dämpfung einstellt und dass der **durch** die erste Spule (L1) fließende Strom während einer Schaltperiode der Schaltelemente (T1, T2) der ersten Halbbrücke mindestens zweimal sein Vorzeichen wechselt.

8. Verfahren zum Betreiben einer Hochdrucklampe (120) mit einer Schaltung nach Anspruch 1, mit
- in einem Zündmodus
- Speisen der Hochdrucklampe (120) mit einer Spannung aus der zweiten Halbbrücke (110-2) mit einem Wechselstrom, deren Frequenz einer Resonanzfrequenz des Resonanzkreises, der sich aus der zweiten Spule (L2) und dem zweiten Kondensator (C2) zusammensetzt, oder einem ungeradzahligen Bruchteil davon entspricht, und Erzeugen einer zum Zünden der Hochdrucklampe (120) erforderlichen Zündspannung.
- Entkoppeln der ersten Spule (L1) und des ersten Kondensators (C1) von der zweiten Spule (L2) und dem zweiten Kondensator (C2) mittels der Hochdrucklampe (120),
- Anregen des Resonanzkreises bei seiner Eigenresonanzfrequenz aufgrund der Entkopplung, um eine genügend hohe Zündspannung für die Hochdrucklampe (120) zur Verfügung zu stellen.
mindestens in einem Betriebsmodus
- wobei der durch die Hochdrucklampe (120) fließende Strom einerseits einen durch ein niederfrequentes Schalten der zweiten Halbbrücke (T3, T4) erzeugten Niederfrequenzanteil und andererseits einen durch ein hochfrequentes Schalten der ersten Halbbrücke (T1, T2) erzeugten Hochfrequenzanteil hat,
- Herausfiltern von mindestens im Wesentlichen hochfrequenten Anteilen aus einem durch die Hochdrucklampe (120) fließenden Strom mit Hilfe des aus der ersten Spule (L1) und dem erste Kondensator (C1) zusammengesetzten Filters und
- Ableiten von Hochfrequenzanteilen des durch den ersten Kondensator (C1) fließenden Stroms, wobei die Anordnung der Kondensatoren (C1, C2) mindestens im Zündmodus die erste Halbbrücke (110-1) von der zweiten Halbbrücke (110-2) entkoppelt.

9. Verfahren nach Anspruch 8, **dadurch gekennzeichnet, dass** der Zündmodus mindestens 1 Sekunde lang aufrechterhalten bleibt und dass danach sofort in den normalen Betriebsmodus umgeschaltet wird.

10. Verfahren nach Anspruch 9, **dadurch gekennzeichnet, dass** nach dem Zünden der Hochdrucklampe (120) die Schaltfrequenz der zweiten Halbbrücke (110-2) und damit die Frequenz des durch die Hochdrucklampe (120) fließenden Stroms abgesenkt wird.

11. Verfahren nach Anspruch 8, **dadurch gekennzeichnet, dass** die Schaltelemente (T1, T2, T3, T4) der ersten Halbbrücke (110-1) und/oder der zweiten Halbbrücke (110-2) nach dem Prinzip des spannungslosen Schaltens betrieben werden.

## Revendications

1. Circuit électronique (100) pour faire fonctionner une lampe à haute pression (120) dans un mode d'allumage et un mode de fonctionnement normal, comprenant :
- un convertisseur CC - CA comprenant un premier et un deuxième demi-ponts (110-1, 110-2) qui sont connectés en parallèle entre une tension de fonctionnement (+) et une tension de référence (-) pour procurer un courant alternatif qui convient à la lampe à haute pression (120) dans lesdits deux modes de fonctionnement; et
- une disposition en série comprenant une première bobine (L1) suivie de la lampe à haute pression (120), elle-même suivie par une deuxième bobine (L2), tandis que la borne de connexion de la première bobine (L1) non connectée à la lampe à haute pression (120) est connectée à la sortie (112-1) du premier demi-pont (110-1), et la borne de connexion de la deuxième bobine (L2) non connectée à la lampe à haute pression (120) est connectée à la sortie (112-2) du deuxième demi-pont (110-2), lesdites sorties étant chacune formée par une sortie centrale d'un demi-pont; **caractérisé par** :
- un premier condensateur (C1) qui, dans le chemin du point de jonction de la première bobine (L1) à la lampe à haute pression (120), est connecté soit à la tension de référence (-) soit à la tension de fonctionnement (+), de façon que
- la première bobine (L1) et le premier condensateur (C1) forment ensemble un filtre qui, au moins en mode opérationnel, filtre au moins des composantes à haute fréquence du courant qui circule au travers de la lampe à haute pression (120), et
- un deuxième condensateur (C2) qui, dans le chemin du point de jonction de la lampe à haute pression (120) à la deuxième bobine (L2), est connecté soit à la tension de référence (-) soit à la tension de fonctionnement (+) de façon que
- la deuxième bobine (L2) et le deuxième condensateur (C2) forment ensemble un circuit résonant qui, dans le mode d'allumage, est alimenté avec une tension fournie par le deuxième demi-pont (110-2), de façon à générer une tension d'allumage nécessaire pour allumer la lampe à haute pression (120),
- où la disposition des condensateurs (C1, C2) est telle que, dans le mode non allumé, la lampe à haute pression (120) déconnecte le premier demi-pont (110-1) avec le circuit de filtre qui y est connecté, y compris la première bobine 1 et le premier condensateur (C1), du deuxième demi-pont (110-2) avec le deuxième circuit résonant qui y est connecté, y compris la deuxième bobine (L2) et le deuxième condensateur (C2), de façon à exciter le deuxième circuit résonant à sa fréquence de résonance naturelle f_{R2}, de façon à rendre disponible une tension d'allumage suffisamment élevée pour la lampe à haute pression (120).

2. Circuit selon la revendication 1, **caractérisé en ce qu'**un troisième condensateur (C3) est connecté entre la sortie (112-1) du premier demi-pont (110-1) et soit la tension de fonctionnement (+) soit la tension de référence (-).

3. Circuit selon la revendication 1, **caractérisé en ce qu'**un troisième condensateur (C3) est connecté entre la sortie (112-1) du premier demi-pont (110-1) et la tension de référence (-), et **en ce qu'**un quatrième condensateur (C4) est connecté entre la tension de fonctionnement (+) et la sortie (112-1) du premier demi-pont (110-1).

4. Circuit selon la revendication 1, **caractérisé en ce qu'**un cinquième condensateur (C5) est connecté entre la sortie du deuxième demi-pont (112-2) et la tension de fonctionnement (+), et / ou **en ce qu'**un sixième condensateur (C6) est connecté entre la tension de référence (-) et la sortie (112-2) du deuxième demi-pont (110-2).

5. Circuit selon la revendication 1, **caractérisé par**
- un dispositif détecteur (130) pour générer un signal de détecteur de courant qui représente la valeur du courant au travers de la première bobine (L1); et par
- un dispositif comparateur (140) pour comparer la valeur représentée par le signal de détecteur de courant avec une valeur de courant de référence donnée I_{R}, et pour générer au moins un signal de commande pour régler le niveau de courant au travers de la première bobine (L1) et au travers de la lampe à haute pression (120) à la valeur du courant de référence donné I_{R}, par une variation qui convient des rapports cycliques des éléments de commutation (T1, T2) du premier demi-pont (110-1).

6. Circuit selon la revendication 5, **caractérisé en ce que** le dispositif détecteur (130) est construit comme un détecteur magnétorésistif.

7. Circuit selon la revendication 5, **caractérisé par** un dispositif de retard (150) pour retarder le signal de commande pour commander les éléments de commutation (T1, T2) du premier demi-pont (110-1) d'un délai de retard donné par rapport au moment où il est détecté que le niveau dépasse la valeur de référence I_{R} vers le haut ou vers le bas, lequel délai de retard est défini tel que au moins un amortissement critique souhaité s'établisse lui-même dans un filtre qui comprend la deuxième bobine (L2) et le premier condensateur (C1), et que le courant au travers de la première bobine (L1) change de signe au moins deux fois pendant un cycle de commutation des éléments de commutation (T1, T2) du premier demi-pont.

8. Procédé de fonctionnement d'une lampe à haute pression (120) avec un circuit selon la revendication 1, dans lequel
- dans un mode d'allumage
- la lampe à haute pression (120) est alimentée avec une tension venant du deuxième demi-pont (110-2) avec un courant alternatif dont la fréquence correspond à une fréquence de résonance du circuit résonant composé de la deuxième bobine (L2) et du deuxième condensateur (C2) ou à une fraction impaire de celle-ci, et une tension d'allumage est générée, nécessaire pour allumer la lampe à haute pression (120),
- la première bobine (L1) et le premier condensateur (C1) sont découplés de la deuxième bobine (L2) et du deuxième condensateur (C2) par la lampe à haute pression (120),
- le circuit résonant est excité à sa fréquence naturelle de résonance du fait du découplage, de façon à rendre disponible une tension d'allumage suffisamment élevée pour la lampe à haute pression (120),
- au moins dans un mode de fonctionnement
- le courant au travers de la lampe à haute pression a d'une part une composante à basse fréquence générée par une commutation à basse fréquence du deuxième demi-pont (T3, T4) et d'autre part une composante à haute fréquence générée par une commutation à haute fréquence du premier demi-pont (T1, T2),
- des composantes à haute fréquence sont, au moins substantiellement, éliminées par filtrage d'un courant qui circule au travers de la lampe à haute pression (120), par le filtre composé de la première bobine (L1) et du premier condensateur (C1), et
- des composantes à haute fréquence du courant au travers du premier condensateur (C1) sont évacuées, où la disposition des condensateurs (C1, C2) découple le premier demi-pont (110-1) du deuxième demi-pont (110-2) au moins en mode d'allumage.

9. Procédé selon la revendication 8, **caractérisé en ce que** le mode d'allumage est maintenu pendant au moins une seconde, et **en ce que**, immédiatement après cela, une commutation est faite au mode de fonctionnement normal.

10. Procédé selon la revendication 9, **caractérisé en ce que**, après allumage de la lampe à haute pression (120), la fréquence de commutation du deuxième demi-pont (110-2), et donc la fréquence du courant au travers de la lampe à haute pression (120), est réduite.

11. Procédé selon la revendication 8, **caractérisé en ce que** les éléments de commutation (T1, T2, T3, T4) du premier demi-pont (110-1) et / ou du deuxième demi-pont (110-2) sont actionnés par le principe d'une commutation sans tension.
